# EUROPEAN PATENT APPLICATION

(11) **EP 2 197 036 A1**
(43) Date of publication of application: **16.06.2010**
(21) Application number: 08832041.1
(22) Date of filing: 29.08.2008
(51) Int. Cl.: H01L 31/04

(54) **METHOD FOR MANUFACTURING SOLAR CELL**

(30) Priority: 19.09.2007 JP 2007242137
(71) Applicant: Sharp Kabushiki Kaisha, Osaka-shi, Osaka 545-8522 (JP)
(72) Inventor: KOHRA, Masatsugu, Osaka-shi, Osaka 545-8522 (JP); FUNAKOSHI, Yasushi, Osaka-shi, Osaka 545-8522 (JP)
(74) Representative: Müller - Hoffmann & Partner
(86) International application number: PCT/JP2008/065505
(87) International publication number: WO 2009/037955

(57) **Abstract**

Disclosed is a method for manufacturing a solar cell, which includes the steps of: applying a first diffusing agent (3) containing n-type impurities and a second diffusing agent (4) containing p-type impurities onto a semiconductor substrate (1); forming a protective layer (5) covering at least one of the first diffusing agent (3) and the second diffusing agent (4); and diffusing at least one of the n-type impurities and the p-type impurities in a surface of the semiconductor substrate (1) by heat treatment of the semiconductor substrate (1) having the protective layer (5) formed thereon.

## Description

### TECHNICAL FIELD

The present invention relates to a method for manufacturing a solar cell, and particularly to a method for manufacturing a solar cell which allows stable production of a solar cell having high electrical characteristics.

### BACKGROUND ART

The great majority of solar cells currently mass-produced are manufactured as a double-sided electrode type solar cell in which a silicon substrate has an n electrode formed on its light-receiving surface and a p electrode formed on its back surface.

In the double-sided electrode type solar cell, however, while the n electrode formed on the light-receiving surface is indispensable for obtaining the current generated by the incident sunlight from the outside, the sunlight is not incident on the silicon substrate below the n electrode, in which area no current is generated.

Thus, for example, the specification of US patent No. 4927770 (Patent Document 1) discloses a back electrode type solar cell having no electrode formed on its light-receiving surface, but having an n electrode and a p electrode formed on the back surface thereof.

In this solar cell, since the incident sunlight is not interrupted by the electrode formed on the light-receiving surface, a high conversion efficiency can be expected in principle.

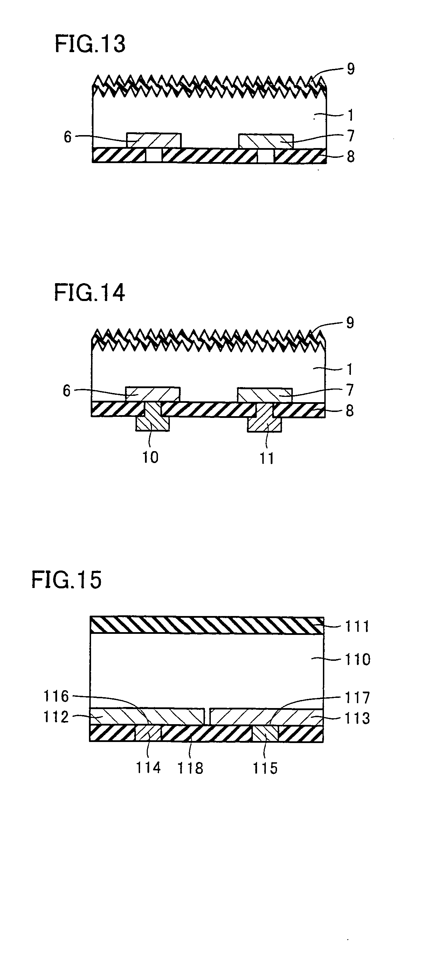

Fig. 15 is a schematic cross-sectional view showing the schematic configuration of a conventional back electrode type solar cell disclosed in Patent Document 1. In this case, on the back surface of an n-type silicon substrate 110, a p-type doping region 112 formed of p-type impurities diffused in high concentration and an n-type doping region 113 formed of n-type impurities diffused higher in concentration than other regions in n-type silicon substrate 110 are arranged in an alternating manner to face each other.

Furthermore, n-type silicon substrate 110 has a passivation film 111 formed on its light-receiving surface and a passivation film 118 formed also on the back surface thereof. These passivation films serve to prevent recombination of carriers. In addition, on the back surface of n-type silicon substrate 110, passivation film 118 is partially removed to provide contact holes 116 and 117.

Then, a p electrode 114 is formed on p-type doping region 112 through contact hole 116, and an n electrode 115 is formed on n-type doping region 113 through contact hole 117. Through these electrodes, the current is obtained. Furthermore, passivation film 111 on the light-receiving surface of n-type silicon substrate 110 also serves as an antireflection film.

This back electrode type solar cell can be manufactured, for example, as described below. First, an oxide silicon film is formed on each of the light-receiving surface and the back surface of n-type silicon substrate 110, and then, a nitride silicon film is formed by the plasma CVD (chemical vapor deposition) method to form passivation films 111 and 118.

Then, the photolithography technique is used to remove a part of passivation film 118 on the back surface of n-type silicon substrate 110, to provide contact hole 117. The CVD method is then used to deposit a glass layer containing n-type impurities on the entire back surface of n-type silicon substrate 110.

After removal of a portion of the glass layer corresponding to the portion where p-type doping region 112 is formed, the photolithography technique is used to remove a portion of passivation film 118 corresponding to the removed portion, to provide contact hole 116. Then, the CVD method is used to deposit a glass layer containing p-type impurities on the back surface of n-type silicon substrate 110.

Then, n-type silicon substrate 110 having the glass layer deposited thereon in this way is heated to 900 °C, to form p-type doping region 112 and n-type doping region 113 on the back surface of n-type silicon substrate 110.

The glass layer deposited on passivation film 118 is then completely removed, and n-type silicon substrate 110 is subjected to heat treatment at a high temperature of 900 °C or higher under hydrogen atmosphere. This causes the interface between n-type silicon substrate 110 and the oxide silicon film of passivation film 118 to be subjected to hydrotreatment.

Then, after removal of the glass layer remaining on p-type doping region 112 and n-type doping region 113, an aluminum film is deposited on the back surface of n-type silicon substrate 110 by the sputtering method. By patterning the aluminum film using the photolithography technique, p electrode 114 is formed on p-type doping region 112 and n electrode 115 is formed on n-type doping region 113. Consequently, the conventional back electrode type solar cell disclosed in Patent Document 1 shown in Fig. 15 is obtained.

Furthermore, Japanese Patent National Publication No. 2002-539615 (Patent Document 2) discloses a dopant paste containing n-type impurities such as phosphorus or p-type impurities such as boron.
Patent Document 1: US patent No. 4927770
Patent Document 2: Japanese Patent National Publication No. 2002-539615

### DISCLOSURE OF THE INVENTION

### PROBLEMS TO BE SOLVED BY THE INVENTION

However, in the case where the dopant paste containing n-type impurities or p-type impurities is applied onto a silicon wafer, which is then subjected to heat treatment at a high temperature to thereby form an n+ diffusion layer and a p+ diffusion layer for manufacturing a solar cell, the n-type impurities or p-type impurities contained in the dopant paste may be diffused in the region other than those where the targeted n+ diffusion layer and p+ diffusion layer are formed. This causes degradation of the electrical characteristics of the solar cell. Specifically, the back electrode type solar cell is significantly affected by the n+ diffusion layer and the p+ diffusion layer formed in the same surface.

In view of the foregoing, an object of the present invention is to provide a method for manufacturing a solar cell which allows stable production of a solar cell having high electrical characteristics.

### MEANS FOR SOLVING THE PROBLEMS

The present invention provides a method for manufacturing a solar cell, including the steps of: applying a first diffusing agent containing n-type impurities and a second diffusing agent containing p-type impurities onto a semiconductor substrate; forming a protective layer covering at least one of the first diffusing agent and the second diffusing agent; and diffusing at least one of the n-type impurities and the p-type impurities in a surface of the semiconductor substrate by heat treatment of the semiconductor substrate having the protective layer formed thereon.

In the method for manufacturing the solar cell according to the present invention, it is preferable that the n-type impurities include at least one of phosphorus and a phosphorus compound, and the p-type impurities include at least one of boron and a boron compound.

Furthermore, in the method for manufacturing the solar cell according to the present invention, it is preferable that at least one of the first diffusing agent and the second diffusing agent is applied by printing.

Furthermore, in the method for manufacturing the solar cell according to the present invention, it is preferable that at least one of the first diffusing agent and the second diffusing agent is baked prior to formation of the protective layer.

Furthermore, in the method for manufacturing the solar cell according to the present invention, it is preferable that the protective layer is an oxide film.

Furthermore, in the method for manufacturing the solar cell according to the present invention, it is preferable that the oxide film has a film thickness of 200 nm or more.

Furthermore, in the method for manufacturing the solar cell according to the present invention, it is preferable that the heat treatment is performed at a temperature of 800 °C or higher and 1100 °C or lower.

Furthermore, in the method for manufacturing the solar cell according to the present invention, it is preferable that the n-type impurities and the p-type impurities are diffused in a same surface of the semiconductor substrate.

Furthermore, in the method for manufacturing the solar cell according to the present invention, the semiconductor substrate is an n-type, and an n+ diffusion layer formed by diffusing the n-type impurities and a p+ diffusion layer formed by diffusing the p-type impurities are formed so as to be spaced apart from each other.

### EFFECTS OF THE INVENTION

According to the present invention, a method for manufacturing a solar cell which allows stable production of a solar cell having high electrical characteristics can be provided.

### BRIEF DESCRIPTION OF THE DRAWINGS

Fig. 1 is a schematic cross-sectional view for illustrating a part of the manufacturing process of an example of a method for manufacturing a solar cell according to the present invention.
Fig. 2 is a schematic cross-sectional view for illustrating a part of the manufacturing process of the example of the method for manufacturing the solar cell according to the present invention.
Fig. 3 is a schematic cross-sectional view for illustrating a part of the manufacturing process of the example of the method for manufacturing the solar cell according to the present invention.
Fig. 4 is a schematic cross-sectional view for illustrating a part of the manufacturing process of the example of the method for manufacturing the solar cell according to the present invention.
Fig. 5 is a schematic cross-sectional view for illustrating a part of the manufacturing process of the example of the method for manufacturing the solar cell according to the present invention.
Fig. 6 is a schematic cross-sectional view for illustrating a part of the manufacturing process of the example of the method for manufacturing the solar cell according to the present invention.
Fig. 7 is a schematic cross-sectional view for illustrating a part of the manufacturing process of the example of the method for manufacturing the solar cell according to the present invention.
Fig. 8 is a schematic cross-sectional view for illustrating a part of the manufacturing process of the example of the method for manufacturing the solar cell according to the present invention.
Fig. 9 is a schematic cross-sectional view for illustrating a part of the manufacturing process of the example of the method for manufacturing the solar cell according to the present invention.
Fig. 10 is a schematic cross-sectional view for illustrating a part of the manufacturing process of the example of the method for manufacturing the solar cell according to the present invention.
Fig. 11 is a schematic cross-sectional view for illustrating a part of the manufacturing process of the example of the method for manufacturing the solar cell according to the present invention.
Fig. 12 is a schematic cross-sectional view for illustrating a part of the manufacturing process of the example of the method for manufacturing the solar cell according to the present invention.
Fig. 13 is a schematic cross-sectional view for illustrating a part of the manufacturing process of the example of the method for manufacturing the solar cell according to the present invention.
Fig. 14 is a schematic cross-sectional view for illustrating a part of the manufacturing process of the example of the method for manufacturing the solar cell according to the present invention.
Fig. 15 is a schematic cross-sectional view of a conventional back electrode type solar cell.

### DESCRIPTION OF THE REFERENCE SIGNS

1, 110 n-type silicon substrate, 2 protective film, 3, 4 diffusing agent, 5 protective layer, 6 n+ diffusion layer, 7 p+ diffusion layer, 8, 111, 118 passivation film 9 antireflection film, 10, 115 n electrode, 11, 114 p electrode, 112 p-type doping region, 113 n-type doping region, 116, 117 contact hole.

### BEST MODES FOR CARRYING OUT THE INVENTION

The embodiments of the present invention will be hereinafter described. In addition, in the accompanying drawings of the present invention, the same or corresponding components are designated by the same reference characters.

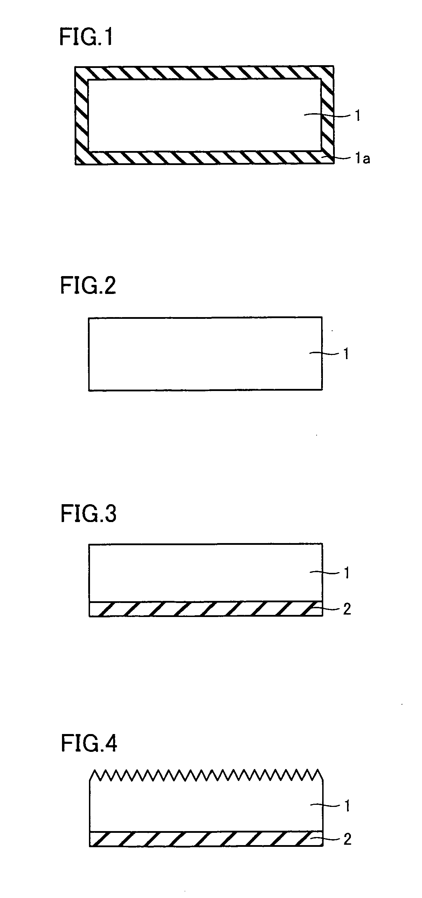

Referring to the schematic cross-sectional views in Figs. 1-14, an example of the method for manufacturing a solar cell according to the present invention will then be described.

First, as shown in Fig. 1, a damage layer la on the surface of an n-type silicon substrate 1 is etched, for example, by using an acid or alkaline solution and removed as shown in Fig. 2.

Then, as shown in Fig. 3, a protective film 2 made, for example, of a silicon oxide film or a silicon nitride film is formed on one surface of n-type silicon substrate 1. In this case, protective film 2 made of the silicon oxide film can be formed, for example, by the atmospheric pressure CVD method performed using silane gas and oxygen.
Also, protective film 2 made of the silicon nitride film can be formed, for example, by the plasma CVD method performed using silane gas, ammonia gas and nitrogen gas.

Then, as shown in Fig. 4, a fine concavo-convex structure referred to as a texture structure is formed on the surface of n-type silicon substrate 1 where protective film 2 is not formed. In this case, the texture structure can be formed, for example, by immersing n-type silicon substrate 1 having protective film 2 formed thereon in the solution of about 80 °C containing potassium hydroxide and isopropyl alcohol (IPA).

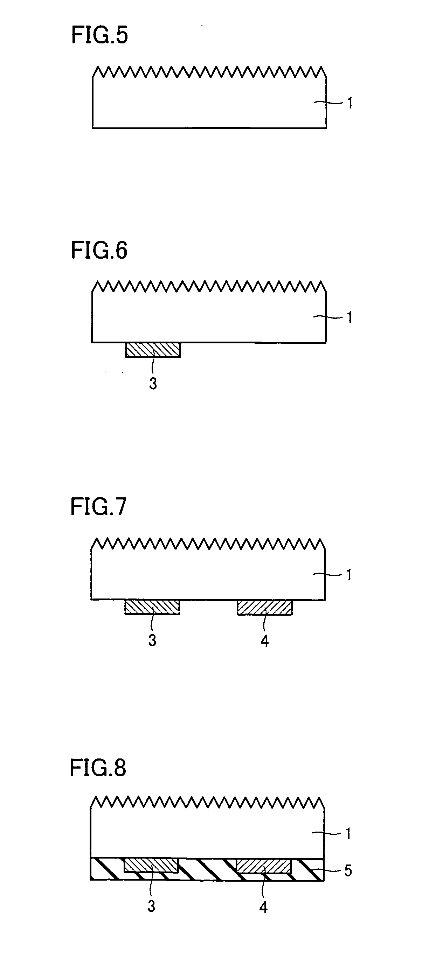

Then, as shown in Fig. 5, n-type silicon substrate 1 is immersed in hydrofluoric acid to thereby etch and remove protective film 2.

Although the texture structure is formed only on one surface of n-type silicon substrate 1 in the above description, the texture structure may be formed on both surfaces of n-type silicon substrate 1 in the present invention. Furthermore, it is preferable that the plane orientation of the surface on which the texture structure is formed is (100). In addition, the process of forming the above-described texture structure may be performed after formation of the diffusion layer described below.

Then, an n+ diffusion layer and a p+ diffusion layer are selectively formed in the same surface of n-type silicon substrate 1. As shown in Fig. 6, a diffusing agent 3 containing n-type impurities is applied onto a part of the surface of n-type silicon substrate 1 exposed by removing protective film 2. In this case, it is preferable that application of diffusing agent 3 containing n-type impurities is carried out by printing using the screen printing method, the gravure printing method, the inkjet printing method, or the like because diffusing agent 3 containing n-type impurities can be selectively applied onto the surface of n-type silicon substrate 1.

As shown in Fig. 7, in the same surface as that of n-type silicon substrate 1 onto which diffusing agent 3 containing n-type impurities is applied, a diffusing agent 4 containing p-type impurities is then applied onto a portion spaced at a predetermined distance from the position where diffusing agent 3 containing n-type impurities is formed. In this case, it is preferable that application of diffusing agent 4 containing p-type impurities is also carried out by printing using the screen printing method, the gravure printing method, the inkjet printing method, or the like because diffusing agent 4 containing p-type impurities can be selectively applied onto the surface of n-type silicon substrate 1.

It is to be noted that diffusing agent 3 containing n-type impurities may be formed of any component that allows diffusion of the n-type impurities, and it can be formed of components containing, for example, a silicon compound, an organic solvent and a thickening agent, except for n-type impurities.

Furthermore, diffusing agent 4 containing p-type impurities may be formed of any component that allows diffusion of the p-type impurities, and it can be formed of components containing, for example, a silicon compound, an organic solvent and a thickening agent, except for p-type impurities.

As for the silicon compound which may be contained in diffusing agent 3 containing n-type impurities and/or diffusing agent 4 containing p-type impurities, for example, tetramethoxysilane, tetraethoxysilane, tetrabutoxysilane, tetrapropoxysilane, and the like can be used alone or in combination thereof, which more specifically includes silane having a longer alkyl chain, silane having various alkyl residues, or the like.

Furthermore, as for the organic solvent which may be contained in diffusing agent 3 containing n-type impurities and/or diffusing agent 4 containing p-type impurities, for example, ethylene glycol monomethyl ether, propylene glycol monomethyl ether or the like can be used.

Furthermore, as for the thickening agent which may be contained in diffusing agent 3 containing n-type impurities and/or diffusing agent 4 containing p-type impurities, for example, a cellulose compound, polyvinyl pyrrolidone, gelatin or the like can be used.

Furthermore, in the above description, it is preferable to use, for example, phosphorus and/or a phosphorus compound as n-type impurities contained in diffusing agent 3 that contains n-type impurities. It is also preferable to use, for example, boron and/or a boron compound as p-type impurities contained in diffusing agent 4 that contains p-type impurities.

It is preferable that the viscosity of each of the above-described diffusing agents 3 and 4 can be adjusted and the viscosity is adjusted in accordance with the printing method used in the application process. Furthermore, the printing method can also be selected in accordance with the viscosity of each of diffusing agent 3 and diffusing agent 4.

In addition, after application of diffusing agent 3 and diffusing agent 4, each of diffusing agents 3 and 4 may be dried. In this case, diffusing agent 3 and diffusing agent 4 can be dried, for example, by heating these applied diffusing agents 3 and 4, for example, to about 200 °C. As diffusing agent 3 and diffusing agent 4 are heated to a temperature of about 200 °C, a volatile component contained in each of diffusing agent 3 and diffusing agent 4 can be removed in advance. Furthermore, it may also be that, after one of diffusing agents 3 and 4 is applied and dried, the other of the diffusing agents is applied and dried.

Furthermore, after diffusing agent 3 and diffusing agent 4 are dried, each of diffusing agents 3 and 4 may be baked. In this case, it is preferable that diffusing agent 3 and diffusing agent 4 are baked by heating these diffusing agents 3 and 4, for example, to a temperature of 200 °C to 500 °C, which is preferably performed under oxygen atmosphere.

The baking process carried out as described above allows solidification and/or densification of diffusing agent 3 and diffusing agent 4, and also allows the baking process to be eliminated when diffusing agent 3 and diffusing agent 4 are solidified by the drying process. It is to be noted that the order in which diffusing agent 3 and diffusing agent 4 are applied may be reversed in the above description.

As shown in Fig. 8, on the surface of n-type silicon substrate 1 on which diffusing agent 3 and diffusing agent 4 are formed, a protective layer 5 is then formed so as to cover diffusing agent 3 and diffusing agent 4. Although protective layer 5 is formed so as to cover both of diffusing agent 3 and diffusing agent 4 in the present embodiment, it only needs to be formed so as to cover at least one of diffusing agent 3 and diffusing agent 4 in the present invention. In other words, since protective layer 5 covers one of diffusing agent 3 and diffusing agent 4, the impurities can be effectively prevented from entering the other diffusion region.

Furthermore, it is preferable that protective layer 5 is formed so as to cover the entire surface of n-type silicon substrate 1 on which diffusing agent 3 and diffusing agent 4 are formed. Since protective layer 5 is formed so as to cover the entire surface of n-type silicon substrate 1, the impurities can be effectively prevented from entering the area other than the diffusion region.

Furthermore, while no particular limitation is imposed on protective layer 5 as long as it performs a function of preventing entrance of n-type impurities and/or p-type impurities, it is preferable to use a silicon oxide film. The silicon oxide film used as protective layer 5 can be formed using an oxidizing agent. For example, in the case where the paste containing a silicon compound, an organic solvent, a thickening agent, and the like is used as an oxidizing agent, protective layer 5 can be formed by applying the oxidizing agent by spin coating, the screen printing method, the gravure printing method, the inkjet printing method, or the like. It is also preferable that the viscosity of the oxidizing agent used for forming protective layer 5 can be adjusted and the viscosity is adjusted in accordance with the application method. Furthermore, the application method can also be selected in accordance with the viscosity of the oxidizing agent.

It is to be noted that, in addition to the method performed using the oxidizing agent, protective layer 5 made of a silicon oxide film can also be formed, for example, using silane gas and oxygen gas by the atmospheric pressure CVD method.

Furthermore, it is preferable that protective layer 5 made of the above-described silicon oxide film has a thickness of 200 nm or more. Protective layer 5 having a thickness of 200 nm or more tends to be effective for preventing the impurities of diffusing agent 3 and diffusing agent 4 from entering another region in the heat treatment described below.

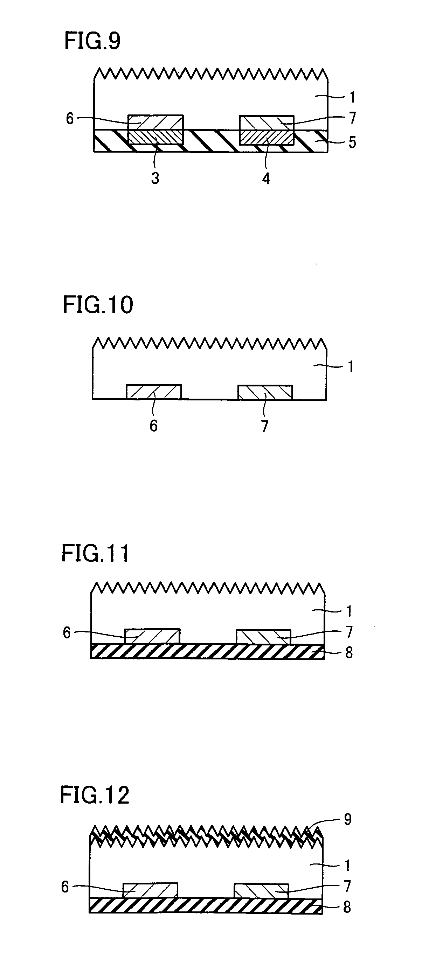

Then, when n-type silicon substrate 1 having protective layer 5 formed thereon is subjected to heat treatment, as shown in Fig. 9, the n-type impurities are diffused from diffusing agent 3 to form an n+ diffusion layer 6 in the surface of n-type silicon substrate 1, and the p-type impurities are diffused from diffusing agent 4 to form a p+ diffusion layer 7 in the surface of n-type silicon substrate 1.

In this case, it is preferable that the heat treatment is performed at a temperature of 800 °C or higher and 1100 °C or lower. In the case where the heat treatment is performed at a temperature of 800 °C or higher and 1100 °C or lower, the electrical characteristics of the solar cell according to the present invention tends to be enhanced. Each concentration of the n-type impurities in n+ diffusion layer 6 and the p-type impurities in p+ diffusion layer 7 tends to be increased in proportion to the level of the heat treatment temperature. Accordingly, the concentration of the impurities in the diffusion layer is decreased when this heat treatment temperature is lower than 800 °C, and the concentration of the impurities in the diffusion layer is increased when this heat treatment temperature is higher than 1100 °C. Thus, the electrical characteristics of the solar cell according to the present invention is more likely to be degraded both in the case where the heat treatment temperature is lower than 800 °C and higher than 1100 °C.

Also in the present invention, for example, as shown in Fig. 9, it is preferable that n+ diffusion layer 6 and p+ diffusion layer 7 are formed so as to be spaced apart from each other such that the region having the same conductivity type as that of n-type silicon substrate 1 (that is, the region of n-type silicon substrate 1) is formed between n+ diffusion layer 6 and p+ diffusion layer 7. In order to form n+ diffusion layer 6 and p+ diffusion layer 7 so as to be spaced apart from each other, it is preferable that diffusing agent 3 and diffusing agent 4 are applied onto the surface of n-type silicon substrate 1 so as to be spaced apart from each other.

Then, as shown in Fig. 10, protective layer 5 is removed. For example, in the case where protective layer 5 is a glass layer, it is preferable to remove protective layer 5 by using HF (hydrofluoric acid).

Then, as shown in Fig. 11, a passivation film 8 is formed on the surface of n-type silicon substrate 1 on which n+ diffusion layer 6 and p+ diffusion layer 7 are formed. In this case, for example, a silicon oxide film, a silicon nitride film, a multilayer film thereof or the like can be used as passivation film 8. The silicon oxide film forming passivation film 8 can be formed, for example, by the thermal oxidation method or the atmospheric pressure CVD method. The silicon nitride film forming passivation film 8 can be formed, for example, by the plasma CVD method. Furthermore, the surface of n-type silicon substrate 1 may be washed by the conventionally known method prior to formation of passivation film 8.

Then, as shown in Fig. 12, an antireflection film 9 is formed on the surface of n-type silicon substrate 1 on which the texture structure is formed. In this case, for example, a nitride film formed by the plasma CVD method can be used as antireflection film 9. The nitride film forming antireflection film 9 may include, for example, a multilayer film formed of a nitride film having a refractive index of approximately 2.4 to 3.2 (particularly, a refractive index of 2.9 or more and 3.2 or less) and a nitride film having a refractive index of approximately 1.9 to 2.2 or a single layer film formed of a film having a refractive index of approximately 1.9 to 2.2.

Then, as shown in Fig. 13, passivation film 8 is partially removed to expose a part of the surface of each of n+ diffusion layer 6 and p+ diffusion layer 7. In this case, partial removal of passivation film 8 can be carried out, for example, by placing the conventionally known etching paste on the surface of passivation film 8 and heating the etching paste, for example, at a temperature of 200 °C to 400 °C, which is followed by washing with water.

Then, as shown in Fig. 14, an n electrode 10 and a p electrode 11 are formed on the surfaces of n+ diffusion layer 6 and p+ diffusion layer 7, respectively, to produce a back electrode type solar cell. In this case, n electrode 10 and p electrode 11 can be formed, for example, by applying the electrode material containing silver onto the exposed surface of each of n+ diffusion layer 6 and p+ diffusion layer 7, which is then dried and/or baked. In addition, n electrode 10 and p electrode 11 can also be formed by using the vapor deposition method.

In the present invention, the n+ diffusion layer and the p+ diffusion layer are formed by the heat treatment performed in the state where the diffusing agent containing n-type impurities and/or the diffusing agent containing p-type impurities are/is covered by a protective layer. This can prevent production of the solar cell in the state where the n-type impurities and the p-type impurities diffuse into the area where diffusion of the impurities is not required during formation of these diffusion layers. Consequently, the degradation of the electrical characteristics of the solar cell resulting from diffusion of these impurities can be effectively suppressed.

Therefore, according to the present invention, a solar cell having high electrical characteristics can be produced with stability.

Although the case where an n-type silicon substrate is used as a semiconductor substrate has been set forth in the above description, a semiconductor substrate other than the n-type silicon substrate, for example, a p-type silicon substrate and the like, can also be used in the present invention.

Furthermore, although the case where a silicon oxide film is used as an oxide film has been set forth in the above description, the oxide film is not limited to a silicon oxide film in the present invention.

Furthermore, although the case where a silicon nitride film is used as a nitride film has been set forth in the above description, the nitride film is not limited to a silicon nitride film in the present invention.

Furthermore, although the case of a back electrode type solar cell has been mainly set forth in the above description, the present invention is not limited to a back electrode type solar cell, but can also be applied to the solar cell such as a double-sided electrode type solar cell other than the back electrode type solar cell. Example

### (Example)

First, an n-type silicon substrate 1 in which the surface has a plane orientation of (100) was prepared as a semiconductor substrate (Fig. 1). Then, a damage layer la on the surface of n-type silicon substrate 1 was removed by etching by using the alkaline solution (Fig. 2).

Then, a protective film 2 made of a silicon oxide film was formed by the atmospheric pressure CVD method as a texture-preventing mask (Fig. 3). Then, n-type silicon substrate 1 having protective film 2 formed thereon was immersed in the solution containing potassium hydroxide and isopropyl alcohol (IPA) at approximately 80°C, to form a texture structure on one surface of n-type silicon substrate 1 (Fig. 4). It was then immersed in hydrofluoric acid to remove protective film 2 of n-type silicon substrate 1 (Fig. 5).

Then, a diffusing agent 3 made of a phosphorus compound, a silicon compound, an organic solvent, and a thickening agent was partially applied onto the surface of the n-type silicon substrate by screen printing, and dried by heating to a temperature of 200 °C under nitrogen atmosphere (Fig. 6). Then, in the same surface as that of n-type silicon substrate 1 onto which diffusing agent 3 containing a phosphorus compound was applied, a diffusing agent 4 made of a boron compound, a silicon compound, an organic solvent, and a thickening agent was partially applied by screen printing so as to be spaced apart from the region where the diffusing agent containing a phosphorus compound was applied. This is followed by heating to 200 °C under nitrogen atmosphere for drying (Fig. 7). Then, diffusing agent 3 and diffusing agent 4 were solidified and densified by baking for 10 minutes under oxygen atmosphere at 400 °C.

Then, on the entire surface of n-type silicon substrate 1 onto which diffusing agent 3 and diffusing agent 4 were applied, a silicon oxide film was formed by the atmospheric pressure CVD method to have a thickness of 300 nm as a protective layer 5 (Fig. 8). Then, n-type silicon substrate 1 having protective layer 5 formed thereon was introduced into a quartz furnace raised to a temperature of approximately 950 °C and held for 50 minutes, to diffuse phosphorus and boron into n-type silicon substrate 1, with the result that an n+ diffusion layer 6 and a p+ diffusion layer 7 were formed so as to be spaced apart from each other (Fig. 9). After formation of n+ diffusion layer 6 and p+ diffusion layer 7, the glass layer remaining on the surface of n-type silicon substrate 1 was removed by hydrofluoric acid (Fig. 10).

Then, the mixed solution of water, hydrochloric acid and hydrogen peroxide solution was heated to approximately 70 °C, in which n-type silicon substrate 1 having the glass layer removed therefrom was immersed, to wash the surface of n-type silicon substrate 1. The surface of n-type silicon substrate 1 was then immersed in hydrofluoric acid for hydrofluoric acid treatment. Then, n-type silicon substrate 1 was introduced into the quartz furnace raised to a temperature of 850 °C under oxygen atmosphere and held for 30 minutes, to form a thermal oxide film on the surface of n-type silicon substrate 1. Then, a silicon oxide film was formed to have a thickness of 200 nm by the atmospheric pressure CVD method, to form a passivation film 8 on the surface of the n-type silicon substrate which had been subjected to the hydrofluoric acid treatment (Fig. 11).

Then, an antireflection film 9 made of a silicon nitride film was formed by the plasma CVD method on the surface of the n-type silicon substrate on which the texture structure was formed. In this case, antireflection film 9 was made of a multilayer film including a silicon nitride film having a refractive index of 3.2 and a silicon nitride film having a refractive index of 2.1 (Fig. 12).

The etching paste containing phosphoric acid as a main component was printed by the screen printing method on the surface area of passivation film 8 corresponding to the position where each of n+ diffusion layer 6 and p+ diffusion layer 7 was formed. The etching paste was subsequently heated for 2 minutes by the hot plate heated to 330 °C. The residue remaining on the surface of the passivation film was washed away by ultrasonic washing with water to expose the surface of each of n+ diffusion layer 6 and p+ diffusion layer 7 (Fig. 13).

Then, a silver paste was printed on the exposed surface of each of n+ diffusion layer 6 and p+ diffusion layer 7. Further, n-type silicon substrate 1 having the silver paste printed thereon was passed through a drying furnace, and baked by heating at a temperature of 500 °C (Fig. 14). This resulted in formation of an n electrode 10 electrically connecting to n+ diffusion layer 6 and a p electrode 11 electrically connecting to p+ diffusion layer 7.

According to the above-described processes, the back electrode type solar cell according to the example of the configuration shown in Fig. 14 was produced.

### (Comparative Example)

In addition, a back electrode type solar cell was produced as a comparative example in a similar manner to the example except that the protective layer was not entirely formed on the surface of the n-type silicon substrate onto which the diffusing agent was applied.

### (Evaluation)

With regard to the back electrode type solar cell according to each of the example and the comparative example produced as described above, a short-circuit current Jsc (mA), an open circuit voltage Voc (V), a fill factor F.F, and a conversion efficiency Eff (%) were measured. The results are shown in Table 1.

**[Table 1]**

| | Jsc (mA) | Voc (V) | F.F | Eff (%) |
|---|---|---|---|---|
| Example | 37.4 | 0.642 | 0.765 | 18.4 |
| Comparative Example | 36.5 | 0.641 | 0.69 | 16.1 |

As shown in Table 1, the back electrode type solar cell according to the example tends to have excellent electrical characteristics regarding all of short-circuit current Jsc, open circuit voltage Voc, fill factor F.F, and conversion efficiency Eff, as compared to the back electrode type solar cell according to the comparative example.

It is considered that this is because diffusion of the n-type impurities and the p-type impurities occurs without formation of a protective layer in the back electrode type solar cell according to the comparative example, which causes diffusion of both of the n-type impurities and the p-type impurities to thereby prevent separation of the n+ diffusion layer and the p+ diffusion layer, leading to leakage of the current, with the result that the electrical characteristics degrade as compared to the back electrode type solar cell according to the example.

It should be understood that the embodiments and the examples disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

According to the present invention, a method for manufacturing a solar cell which allows stable production of a solar cell having high electrical characteristics can be provided.

## Claims

1. A method for manufacturing a solar cell, comprising the steps of:
applying a first diffusing agent (3) containing n-type impurities and a second diffusing agent (4) containing p-type impurities onto a semiconductor substrate (1);
forming a protective layer (5) covering at least one of said first diffusing agent (3) and said second diffusing agent (4); and
diffusing at least one of the n-type impurities and the p-type impurities in a surface of said semiconductor substrate (1) by heat treatment of said semiconductor substrate (1) having said protective layer (5) formed thereon.

2. The method for manufacturing a solar cell according to claim 1, wherein said n-type impurities include at least one of phosphorus and a phosphorus compound, and said p-type impurities include at least one of boron and a boron compound.

3. The method for manufacturing a solar cell according to claim 1, wherein at least one of said first diffusing agent (3) and said second diffusing agent (4) is applied by printing.

4. The method for manufacturing a solar cell according to claim 1, wherein at least one of said first diffusing agent (3) and said second diffusing agent (4) is baked prior to formation of said protective layer (5).

5. The method for manufacturing a solar cell according to claim 1, wherein said protective layer (5) is an oxide film.

6. The method for manufacturing a solar cell according to claim 5, wherein said oxide film has a film thickness of 200 nm or more.

7. The method for manufacturing a solar cell according to claim 1, wherein said heat treatment is performed at a temperature of 800 °C or higher and 1100 °C or lower.

8. The method for manufacturing a solar cell according to claim 1, wherein said n-type impurities and said p-type impurities are diffused in a same surface of said semiconductor substrate (1).

9. The method for manufacturing a solar cell according to claim 8, wherein said semiconductor substrate (1) is an n-type, and an n+ diffusion layer (6) formed by diffusing said n-type impurities and a p+ diffusion layer (7) formed by diffusing said p-type impurities are formed so as to be spaced apart from each other.
